# EUROPEAN PATENT SPECIFICATION

(11) **EP 0 668 656 B1**
(45) Date of publication and mention of the grant of the patent: **16.08.2001**
(21) Application number: 95300959.4
(22) Date of filing: 15.02.1995
(51) Int. Cl.: H03J 5/24

(54) **A tuner for a satellite broadcasting receiver**
Tuner für Satelliten-Rundfunkempfänger
Tuner pour récepteur pour radiodiffusion par satellite

(30) Priority: 18.02.1994 JP 2148694
(43) Date of publication of application: 23.08.1995
(73) Proprietor: SHARP KABUSHIKI KAISHA, Osaka-shi, Osaka-fu 545-0013 (JP)
(72) Inventor: Hori, Makoto, Yamatokoriyama-shi, Nara (JP)
(74) Representative: Brown, Kenneth Richard

(56) References cited:
- EP-A- 0 188 662
- EP-A- 0 401 932

## Description

### BACKGROUND OF THE INVENTION

### (1) Field of the Invention

The present invention relates to a tuner for receiving satellite broadcasting, in particular to a BS tuner which is preferably used for receiving high-frequency input signals over a wide frequency-band range.

### (2) Description of the Prior Art

At present, satellite broadcasting is prevalent worldwide and a great number of channels are used for different systems. In Japan, the government started in 1992 to give permission to practice satellite broadcasting utilizing communication satellites in order to multiply channels for satellite broadcasting.

A number of receiving means for satellite broadcasting have been proposed, and tuners are one of these means.

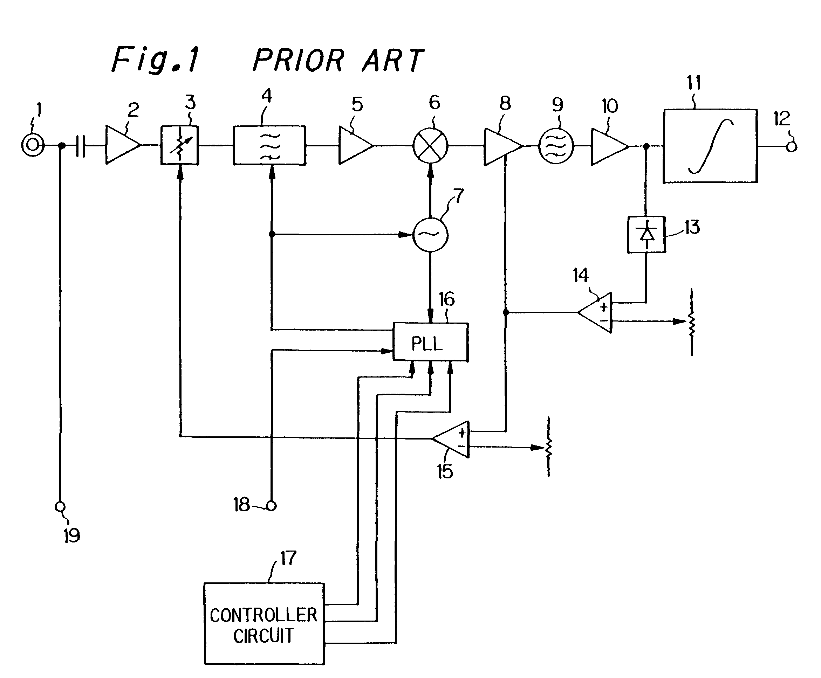

Fig.1 is a block diagram showing a prior art tuner for receiving satellite broadcasting. This figure represents a DBS (direct broadcast satellite) tuner for export to Europe having an input signal range of 950 to 2,050 MHz.

In this figure, a high-frequency signal of a 12 GHz-band picked up by an outdoor receiving antenna, is converted into a high-frequency signal of 1 GHz band through an LNB (low noise blockdown) converter and provided to an input terminal 1. This input signal is amplified in an amplifier circuit 2 and then level-controlled by an attenuation-variable attenuator 3 to be supplied to a variable band-pass filter 4.

The variable band-pass filter 4 can be varied in its receiving frequency band from 950 MHz to 2,050 MHz in accordance with the frequency of a broadcasting station to be tuned. For the tuner to select the signal from a desired broadcasting station, the variable band-pass filter 4 serves to set up a frequency band having a center frequency near to that for the desired broadcasting station so that only the desired signal may be allowed to pass while unnecessary signals such as, for example, image signals etc., is attenuated.

The signal having passed through the filter 4 is amplified in an amplifier circuit 5 and then supplied to a mixer circuit 6, in which the amplified signal is mixed with a locally generated signal (local signal) from a local oscillator circuit 7, to thereby be converted into an intermediate frequency (IF) signal of a 400 MHz band. The thus obtained IF signal is amplified in a gain-variable amplifier circuit 8 and delivered to a band-pass filter 9, which limits the signal band. The output signal from the band-pass filter 9 is amplified in an amplifier circuit 10 and thereafter subjected to FM-detection in an FM demodulating circuit 11 whereby the demodulated signal is outputted from a baseband output terminal 12.

The output from the amplifier circuit 10 is supplied to an AGC (automatic gain control) detecting circuit 13 in which an AGC voltage is detected. The AGC voltage is then amplified in a d.c. amplifier circuit 14 to be fed to the AGC amplifier circuit 8 as a gain control signal. The voltage amplified in the amplifier 14 is further amplified in another d.c. amplifier circuit 15, then the thus processed signal is provided to the attenuation variable attenuator 3 as an attenuation control signal.

A PLL synthesizer 16, in conformity with an input signal for tuning to a desired broadcasting station from a controller circuit 17 composed of, for example, a CPU, outputs a control signal for setting up the oscillation frequency of the local signal outputted from the local oscillator circuit 7 and the center frequency of the variable band-pass filter 4.

A terminal 18 connected to the PLL synthesizer 16 is one for tuning voltage input and a terminal 19 connected to the input terminal 1 is one for power supply of a d.c. voltage to the LNB.

For the above-described conventional DBS tuner, if the tuner is designed to handle input signals over a wide frequency range, it becomes difficult to set up the center frequency near to that of the signal for a desired broadcasting station, therefore it becomes difficult to create a tracking condition. This degrades the functions of the variable band-pass filter 4 for allowing the desired signal to pass therethrough and removing unnecessary signals, causing the selected signal to become susceptible to interferences by image signals etc.

The upside heterodyne scheme using a typical IF signal of 479.5 MHz is adopted in Europe. Accordingly, if the frequency range of the input signals is broadened toward the higher-frequency range, the upper boundary of the frequencies of the local signals becomes high. That is, as the local signal inputted to the PLL synthesizer 16 from the local oscillator circuit 7 is increased in its frequency, it is necessary for the PLL synthesizer to have an improved sensitivity, resulting in an increased production cost of the tuner.

The document EP-A-0 401 932 discloses a satellite broadcast receiver having a series of band-pass filters succeeding each other in band-pass frequency.

### SUMMARY OF THE INVENTION

It is therefore an object of the present invention to provide a tuner for receiving satellite broadcasting which does not require any high-sensitivity PLL synthesizer and wherein the capability of the variable band-pass filter device as an input means will not be deteriorated even when the frequencies of the input signals are taken large.

According to the present invention, there is provided a tuner for receiving satellite broadcasting comprising: a filter means composed of a plurality of variable band-pass filters having different frequency ranges within a frequency band range for high frequency input signals derived from received satellite broadcast signals, and selecting means for selecting one of the variable band-pass filters in conformity with the frequency of a tuned satellite broadcasting station; a frequency converting circuit composed of a local oscillator circuit generating a locally generated oscillating signal corresponding to the frequency of the tuned broadcasting station and a mixer circuit outputting an intermediate frequency signal at a predetermined intermediate frequency by mixing a high-frequency signal having passed through said filter means with said locally generated oscillating signal; and a demodulating circuit for extracting the original wave signal from the intermediate frequency signal, wherein, when the frequency of a tuned broadcasting station is greater than a predetermined level, said frequency converting circuit down converts the tuned high-frequency signal to the intermediate frequency signal at said intermediate frequency based on the downside heterodyne scheme of operation; and when the frequency of a tuned broadcasting station is lower than the predetermined level, said frequency converting circuit down converts the tuned high-frequency signal to the intermediate frequency signal at the same said intermediate frequency based on the upside heterodyne scheme of operation.

In the above case, the demodulating circuit may have a couple of output terminals outputting equivalent demodulated signals but having opposite polarities to each other.

In the above cases, the demodulating circuit may have a switching means on the output side thereof for selecting any one of the couple of output terminals so that one of the demodulated signals having opposite polarities to each other is selected in conformity with the frequency of the broadcasting station tuned.

In an embodiment of the present invention, one of the variable band-pass filters is selected from the filter means in conformity with the frequency of a broadcasting station to be tuned, thereafter the center frequency of the selected filter is adjusted near to the frequency of the broadcasting station selected. Therefore, it is possible to narrow the frequency range of each variable band-pass filter, enabling easy tracking and preventing deterioration of the capability of the filter means for removing interfering waves.

When the frequency of a tuned broadcasting station is lower than a predetermined level, the frequency converting circuit converts the tuned high-frequency signal to the intermediate frequency signal based on the upside heterodyne scheme in which a local signal having a greater frequency than the tuned frequency is set up; and when the frequency of a tuned broadcasting station is greater than the predetermined level, the frequency converting circuit converts the tuned high-frequency signal to the intermediate frequency signal based on the downside heterodyne scheme in which a local signal having a lower frequency than the tuned frequency is used. Accordingly, even if the upper boundary of the receiving frequency range is extended, it is possible to suppress the upper limit of the frequency of the locally oscillating signal within a low range.

### BRIEF DESCRIPTION OF THE DRAWINGS

Fig.1 is a block diagram showing a prior art tuner for receiving satellite broadcasting;
Fig.2 is a block diagram showing an embodiment of a tuner for receiving satellite broadcasting in accordance with the present invention;
Fig.3A is a chart showing a band range width of input signals;
Fig.3B is a chart showing a band range width of local signals used in a high-band receiving mode;
Fig.3C is a chart showing a band range width of local signals used in a low-band receiving mode;
Fig.4 is a block diagram showing another embodiment of a tuner for receiving satellite broadcasting in accordance with the present invention; and
Fig.5 is a block diagram showing a third embodiment of a tuner for receiving satellite broadcasting in accordance with the present invention.

### DESCRIPTION OF THE PREFERRED EMBODIMENTS

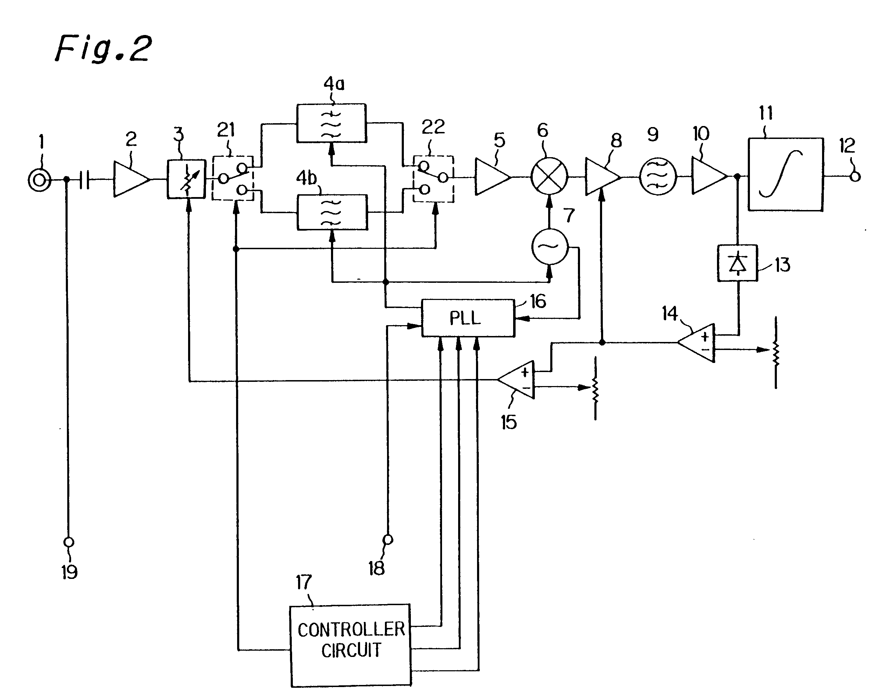

Fig.2 is a block diagram showing a tuner for receiving satellite broadcasting in accordance with the present invention. Here, description will be made assigning the same reference numerals to identical components in the figure with those described in the prior art configuration. Differences of this embodiment from the configuration shown in Fig.1 are that the filter 4 is omitted, a pair of variable band-pass filters 4a and 4b are provided in parallel between an attenuator 3 and an amplifier circuit 5, and a pair of changeover switches 21 and 22 interposed on the side of the attenuator 3 and on the side of amplifier circuit 5, respectively, so that one of the filters 4a and 4b may be selected. Here, a mixer circuit 6 and a local oscillator circuit 7 constitute a frequency converting circuit.

The switching operation of the changeover switches 21 and 22 is done in conformity with a changeover signal provided from a controller circuit 17 composed of, for example, a CPU, etc. Other elements are the same with those in the aforementioned configuration shown in Fig.1.

In this embodiment, the frequency band range of the input signals extends widely from 950 to 2,300 MHz. To deal with this, the frequency range of the input signals is divided by a couple of variable band-pass filters 4a and 4b into two band range, specifically, a first band range for low-frequencies of 950 to 2,050 MHz through the variable band-pass filter 4a and a second band for high-frequencies of 2,050 to 2,300 MHz through the variable band-pass filter 4b.

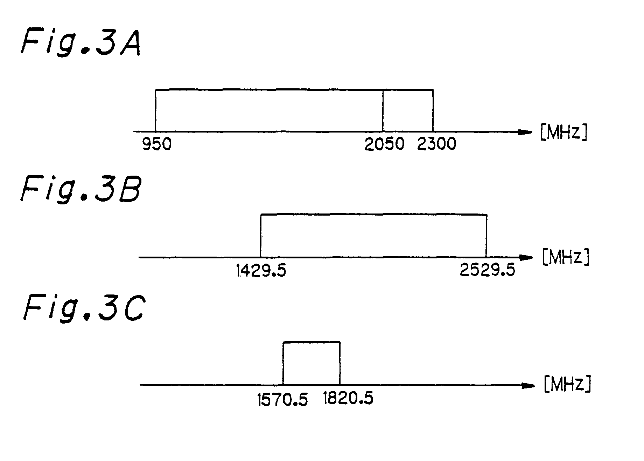

In this situation, when the intermediate frequency is assumed to be 479.5 MHz, the frequencies of the local signals range from 1,429.5 (i.e., 950 + 479.5) MHz to 2,529.5 (i.e., 2,050 + 479.5) MHz for the low-band receiving mode in which the upside heterodyne scheme is adopted while the frequencies of the local signals range from 1,570.5 (i.e., 2,050 - 479.5) MHz to 1,820.5 (i.e., 2,300 - 479.5) MHz for the high-band receiving mode in which the downside heterodyne scheme is adopted. Figs.3A to 3C show an input-signal band width (Fig.3A), a local-signal band width in the high-band receiving mode (Fig.3B) and a local-signal band width in the low-band receiving mode (Fig.3C), respectively.

Accordingly, when the controller circuit 17 sends out a switching signal for the changeover switches 21 and 22 in association with the frequency of a signal tuned, the switches 21 and 22 select one of the two variable band-pass filters 4a and 4b. More specifically, when the frequency of the signal to be tuned falls within the low-band range, the variable band-pass filter 4a is selected while, when the frequency of the signal to be tuned falls within the high-band range, the variable band-pass filter 4b is selected. At the same time, the local frequency generated in the local oscillator circuit 7 is set up such that, at the low-band receiving mode, the upside heterodyne scheme is adopted while, at the high-band receiving mode, the downside heterodyne scheme is adopted.

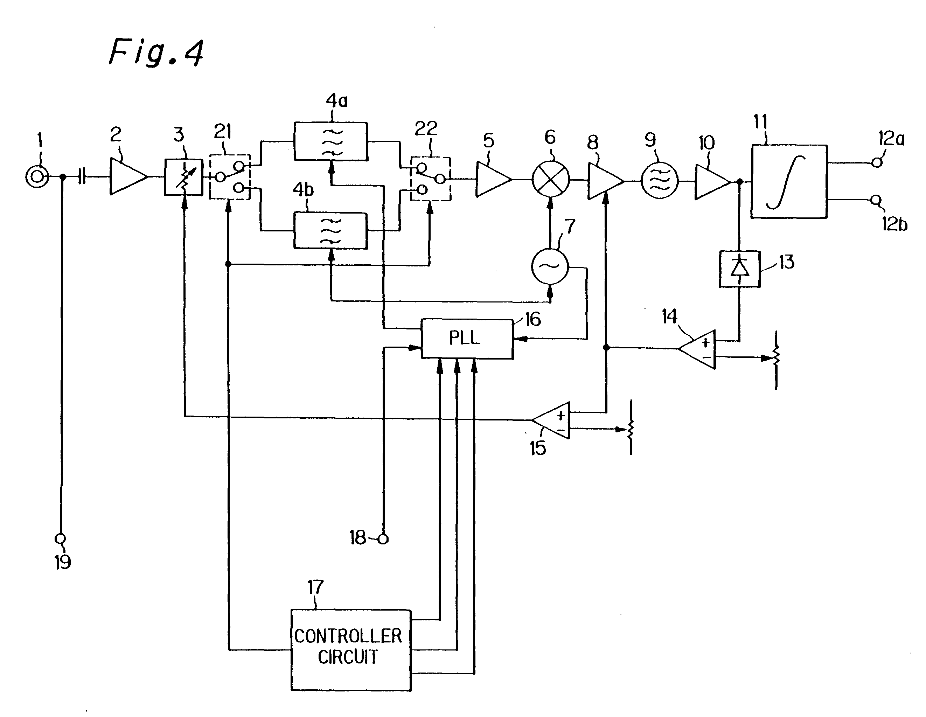

Fig.4 shows another embodiment in which a pair of baseband output terminals 12a and 12b are equipped for the FM demodulating circuit 11. In the present invention, since the frequency conversion is achieved by using both the upside and downside heterodyne schemes, the polarity of the demodulated signal will be inverted depending upon the type of the heterodyne scheme used.

Each of the two output terminals 12a and 12b is adapted to output the equivalent demodulated signals but having the opposite polarity to each other, allowing one of them to be selected in conformity with the frequency of the tuned broadcasting station or depending upon the type of heterodyne scheme. Therefore, by the proper selection, it is possible at any time to maintain the polarity of the demodulated signal fixed, regardless of the frequency of the input signal.

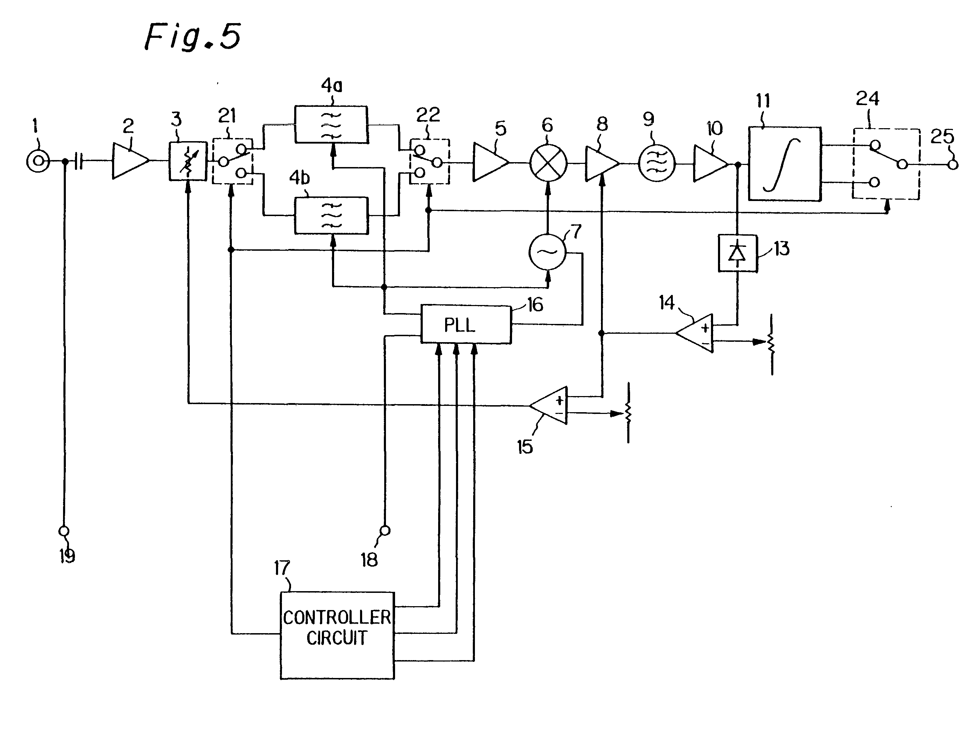

Fig.5 shows a variation of the embodiment shown in Fig.4. In this embodiment, provided on the output side of the FM demodulating circuit 11 is a changeover switch 24 for selecting one of the two demodulated signals having opposite polarities to each other. The changeover switch 24 is configured in such a manner that the switching operation is done in link with the switching signal transmitted from the controller circuit 17. By the operation of the switch, it is possible to obtain at any time the polarity-fixed FM-demodulated signal from a baseband output terminal 25, regardless of the frequency of the input signal (or the selected heterodyne scheme).

Now, the operation of the present invention will be described referring to the cases where a 1,000 MHz high-frequency signal and a 2,200 MHz high-frequency signal are received. At first, when a high-frequency signal of 1,000 MHz is received, the controller circuit 17 sends out a switching signal for the changeover switches 21 and 22, so that the variable band-pass filter 4a is selected from the two variable band-pass filters 4a and 4b to thereby set up a tracking condition for low-band signals.

As the frequency conversion should be effected based on the upside heterodyne scheme, the controller circuit 17 sends out a control signal for the PLL synthesizer 16 to set up a center frequency so that the local frequency may take a value of 1,479.5 (i.e., 1,000 + 479.5) MHz.

Meanwhile, as the FM demodulating circuit 11 is currently formed of an IC device composed of a differential amplifier, it is possible to retrieve from the FM demodulating circuit 11 a couple of demodulating signals having the opposite polarities to each other. Accordingly, when the high-frequency signal of 1,000 MHz is received, the demodulated signal containing the negative synchronization signal is selected as the output by the changeover switch 24.

Next, when a high-frequency signal of 2,200 MHz is to be tuned, the controller circuit 17 sends out a switching signal for the changeover switches 21 and 22, so that the variable band-pass filter 4b is selected from the two variable band-pass filters 4a and 4b to thereby set up a tracking condition for high-band signals.

As the frequency conversion must be effected based on the downside heterodyne scheme, the controller circuit 17 sends out a control signal for the PLL synthesizer 16 to set up a center frequency so that the local frequency may take a value of 1,720.5 (i.e., 2,200 - 479.5) MHz.

In the second case, as the frequency conversion is effected based on the downside heterodyne scheme, the polarity of the demodulated signal is inverted relative to the first case in which the high-frequency signal of 1,000 MHz is received. Therefore, the changeover switch 24 is reversed so that the other demodulated signal having the opposite polarity to that of the demodulated signal selected when the high-frequency signal of 1,000 MHz is received, can be selected from the two output signals from the FM demodulating circuit 11. In this way, it is possible to obtain from the output terminal 25 a demodulated signal of the same polarity containing the negative synchronization signal as obtained when the high-frequency signal of 1,000 MHz is received.

In accordance with the present invention, by selecting one filter from a plurality of variable band-pass filters in conformity with the frequency of a tuned broadcasting station, it is possible to narrow the band range widths of individual filters. Accordingly, even if the frequency range of the input signals is broad, it is possible to pass any high-frequency signal of a desired broadcasting station within the frequency range without degrading the capability of the variable band-pass filters for rejecting interfering waves.

Since the upside heterodyne mode is used when the frequency of the broadcasting station to be tuned falls within the low-band range and the downside heterodyne mode is used when the frequency falls within the high-band range, the frequency of the local signals can be inhibited from becoming higher even when the frequency range of the input signals is large. Hence, it is not necessary to use any high-sensitivity PLL synthesizer and it is therefore possible to suppress the production cost of the tuner.

## Claims

1. A tuner for receiving satellite broadcasting comprising:
a filter means (4a, 4b) composed of a plurality of variable band-pass filters having different frequency ranges within a frequency band range for high frequency input signals derived from received satellite broadcast signals, and selecting means (17) for selecting one of the variable band-pass filters in conformity with the frequency of a tuned satellite broadcasting station;
a frequency converting circuit (6, 7) composed of a local oscillator circuit (7) generating a locally generated oscillating signal corresponding to the frequency of the tuned broadcasting station and a mixer circuit (6) outputting an intermediate frequency signal at a predetermined intermediate frequency by mixing a high-frequency signal having passed through said filter means with said locally generated oscillating signal; and
a demodulating circuit (11) for extracting the original wave signal from the intermediate frequency signal,
wherein, when the frequency of a tuned broadcasting station is greater than a predetermined level, said frequency converting circuit down converts the tuned high-frequency signal to the intermediate frequency signal at said intermediate frequency based on the downside heterodyne scheme of operation; and when the frequency of a tuned broadcasting station is lower than the predetermined level, said frequency converting circuit down converts the tuned high-frequency signal to the intermediate frequency signal at the same said intermediate frequency based on the upside heterodyne scheme of operation.

2. A tuner for receiving satellite broadcasting according to Claim 1 wherein said demodulating circuit (11) has a couple of output terminals outputting equivalent demodulated signals but having opposite polarities to each other.

3. A tuner for receiving satellite broadcasting according to Claim 1 or Claim 2 wherein said demodulating circuit (11) has a switching means (24) on the output side thereof for selecting any one of said couple of output terminals whereby one of the demodulated signals having opposite polarities to each other is selected in conformity with the frequency of the broadcasting station tuned.

4. A tuner for receiving satellite broadcasting according to any preceding claim wherein said filter means is composed of first and second variable band-pass filters (4a, 4b) which divide said frequency band range for the high frequency input signals into a first relatively low frequency range and a second relatively high frequency range, and wherein said predetermined level lies at the frequency where said frequency band range divides, said selecting means and frequency converting circuit being controlled so that any tuned high-frequency signal in said first frequency range is down converted based on the upside heterodyne scheme of operation and any tuned high-frequency signal in said second frequency range is down converted based on the downside heterodyne scheme of operation.

## Patentansprüche

1. Tuner zum Empfangen von Satellitenrundfunk mit:
- einer Filtereinrichtung (4a, 4b) aus mehreren variablen Bandpassfilter mit verschiedenen Frequenzbereichen innerhalb eines Frequenzbandbereichs für hochfrequente Eingangssignale, die aus empfangenen Satellitenrundfunksignalen hergeleitet wurden, und einer Auswähleinrichtung (17) zum Auswählen eines der variablen Bandpassfilter in Übereinstimmung mit der Frequenz einer Satelliten-Rundfunkstation, auf die abgestimmt wurde;
- einer Frequenzwandlerschaltung (6, 7) aus einer Ortsoszillatorschaltung (7), die ein örtlich erzeugtes Schwingungssignal entsprechend der Frequenz der Rundfunkstation, auf die abgestimmt wird, erzeugt, und einer Mischerschaltung (6), die ein Zwischenfrequenzsignal mit einer vorbestimmten Zwischenfrequenz dadurch ausgibt, dass sie ein hochfrequentes Signal, das die Filtereinrichtung durchlaufen hat, mit dem örtlich erzeugten Schwingungssignal mischt; und
- einer Demodulationsschaltung (11) zum Entnehmen des ursprünglichen Signals aus dem Zwischenfrequenzsignal;
- wobei dann, wenn die Frequenz der Rundfunkstation, auf die abgestimmt wird, größer als ein vorbestimmter Wert ist, die Frequenzwandlerschaltung das hochfrequente Signal, auf das abgestimmt wird, auf Grundlage des Unterseiten-Heterodynbetriebssystems auf das Zwischenfrequenzsignal mit der Zwischenfrequenz herunterwandelt, während die Frequenzwandlerschaltung dann, wenn die Frequenz der Rundfunkstation, auf die abgestimmt wird, niedriger als der vorbestimmte Wert ist, das hochfrequente Signal, auf das abgestimmt wird, auf Grundlage des Oberseiten-Heterodynbetriebssystems in ein Zwischenfrequenzsignal derselben Zwischenfrequenz umsetzt.

2. Tuner zum Empfangen von Satellitenrundfunk nach Anspruch 1, bei dem die Demodulationsschaltung (11) ein Paar Ausgangsanschlüsse ausgibt, die äquivalente demodulierte Signale mit entgegengesetzten Polaritäten ausgeben.

3. Tuner zum Empfangen von Anspruch 1 oder Anspruch 2, bei dem die Demodulationsschaltung (11) an ihrer Ausgangsseite eine Umschalteinrichtung (24) zum Auswählen eines des Paars von Ausgangsanschlüssen aufweist, wodurch eines der demodulierten Signale mit einander entgegengesetzten Polaritäten in Übereinstimmung mit der Frequenz der Rundfunkstation, auf die abgestimmt wird, ausgewählt wird.

4. Tuner zum Empfangen von Satellitenrundfunk nach einem der vorstehenden Ansprüche, bei dem die Filtereinrichtung aus einem ersten und einem zweiten variablen Bandpassfilter (4a, 4b) besteht, die den Frequenzbandbereich für die hochfrequenten Eingangssignale in einen ersten Bereich mit relativ niedriger Frequenz und einen zweiten Bereich mit relativ hoher Frequenz unterteilen, und bei dem der vorbestimmte Wert auf derjenigen Frequenz liegt, an der der Frequenzbandbereich unterteilt ist, wobei die Auswähleinrichtung und die Frequenzwandlerschaltung so gesteuert werden, dass jedes hochfrequente Signal, auf das abgestimmt wird, im ersten Frequenzbereich auf Grundlage des Oberseiten-Heterodynbetriebssystems abwärts gewandelt wird und jedes hochfrequente Signal, auf das abgestimmt wird, im zweiten Frequenzbereich auf Grundlage des Unterseiten-Heterodynbetriebssystems abwärts gewandelt wird.

## Revendications

1. Syntoniseur de réception de radiodiffusion par satellite, comprenant :
des moyens formant filtres (4a, 4b) composés de plusieurs filtres passe-bande variables ayant des gammes de fréquences différentes à l'intérieur d'une bande de fréquences correspondant à des signaux d'entrée haute fréquence issus de signaux de radiodiffusion par satellite reçus, et des moyens sélecteurs (17) destinés à sélectionner l'un des filtres passe-bande variables en fonction de la fréquence d'une station de radiodiffusion par satellite accordée;
un circuit convertisseur de fréquence (6, 7) composé d'un circuit oscillateur local (7) qui produit un signal oscillant généré localement correspondant à la fréquence de la station de radiodiffusion accordée et d'un circuit mélangeur (6) qui fournit en sortie un signal de fréquence intermédiaire à une fréquence intermédiaire prédéterminée en mélangeant un signal haute fréquence qui a traversé les moyens formant filtres avec ledit signal oscillant généré localement; et
un circuit démodulateur (11) destiné à extraire le signal d'onde initial du signal de fréquence intermédiaire,
dans lequel, lorsque la fréquence d'une station de radiodiffusion accordée est supérieure à un niveau prédéterminé, ledit circuit convertisseur de fréquence convertit par changement de fréquence le signal haute fréquence accordé en signal de fréquence intermédiaire à ladite fréquence intermédiaire sur la base du système de fonctionnement hétérodyne négatif; et, lorsque la fréquence d'une station de radiodiffusion accordée est inférieure au niveau prédéterminé, ledit circuit convertisseur de fréquence convertit par changement de fréquence le signal haute fréquence accordé en signal de fréquence intermédiaire à cette même fréquence intermédiaire sur la base du système de fonctionnement hétérodyne positif.

2. Syntoniseur de réception de radiodiffusion par satellite selon la revendication 1, dans lequel ledit circuit démodulateur (11) comporte deux bornes de sortie qui délivrent en sortie des signaux démodulés équivalents mais de polarités opposées l'un par rapport à l'autre.

3. Syntoniseur de réception de radiodiffusion par satellite selon la revendication 1 ou la revendication 2, dans lequel ledit circuit démodulateur (11) comporte, du côté de sa sortie, des moyens commutateurs (24) destinés à sélectionner l'une quelconque desdites deux bornes de sortie, pour qu'ainsi l'un des signaux démodulés de polarités opposées l'un par rapport à l'autre soit sélectionné en fonction de la fréquence de la station de radiodiffusion accordée.

4. Syntoniseur de réception de radiodiffusion par satellite selon l'une quelconque des revendications précédentes, dans lequel lesdits moyens formant filtres sont composés de premier et second filtres passe-bande variables (4a, 4b) qui divisent ladite bande de fréquences correspondant aux signaux d'entrée haute fréquence en une première gamme de fréquences relativement basses et en une seconde gamme de fréquences relativement hautes, et dans lequel ledit niveau prédéterminé se situe à la fréquence à laquelle ladite bande de fréquences se divise, lesdits moyens de sélection et ledit circuit convertisseur de fréquence étant commandés de façon que tout signal haute fréquence accordé dans ladite première gamme de fréquences soit converti par changement de fréquence sur la base du système de fonctionnement hétérodyne positif et que tout signal haute fréquence accordé dans ladite seconde gamme de fréquences soit converti par changement de fréquence sur la base du système de fonctionnement hétérodyne négatif.
